# EUROPEAN PATENT APPLICATION

(11) **EP 4 773 334 A1**
(43) Date of publication of application: **08.07.2026**
(21) Application number: 24920715.0
(22) Date of filing: 15.11.2024
(51) Int. Cl.: H01M 10/48, G01R 31/389, G01K 7/42

(54) **BATTERY TEMPERATURE ESTIMATION DEVICE AND METHOD FOR OPERATING SAME**

(30) Priority: 26.01.2024 KR 20240012555
(71) Applicant: LG Energy Solution, Ltd., Seoul 07335 (KR)
(72) Inventor: JO, Yong Min, Daejeon 34122 (KR); YOON, Sun Woo, Daejeon 34122 (KR); PARK, Hye Jin, Daejeon 34122 (KR)
(74) Representative: Hoffmann Eitle
(86) International application number: PCT/KR2024/018077
(87) International publication number: WO 2025/159300

(57) **Abstract**

A battery temperature estimation device according to an embodiment disclosed in this document may include an impedance measurement unit configured to measure frequency-specific impedance of a battery; a memory configured to store a temperature-impedance imaginary part table according to a frequency; and a controller configured to estimate a temperature of the battery through the temperature-impedance imaginary part table based on an imaginary part of the frequency-specific impedance.

## Description

### TECHNICAL FIELD

### CROSS-REFERENCE TO RELATED APPLICATION

This application claims priority to and the benefit of Korean Patent Application No. 10-2024-0012555 filed in the Korean Intellectual Property Office on January 26, 2024, the entire contents of which are incorporated herein by reference.

### TECHNICAL FIELD

The embodiments disclosed in this document relate to a battery temperature estimation device and an operating method thereof.

### BACKGROUND ART

Recently, researches and development of secondary batteries are conducted actively. Here, the secondary batteries are batteries that can be recharged and discharged, and include both conventional Ni/Cd batteries, Ni/MH batteries, and the like and recent lithium-ion batteries. Among the secondary batteries, the lithium-ion batteries are advantageous in that the energy density is much higher than that of the conventional Ni/Cd batteries, Ni/MH batteries, and the like. In addition, as the lithium-ion batteries can be manufactured to be small and lightweight, they are used as a power source for mobile devices, and since their scope of use has been expanded recently to power sources for electric vehicles, they are spotlighted as a next-generation energy storage medium.

Since an outbreak of fire in a battery may cause serious damage to a vehicle or a device that uses the battery, estimating the temperature of the battery is an essential factor in the technique of controlling batteries. Conventionally, a Negative Temperature Coefficient Thermistor (NTC) is used to estimate the temperature of a battery. In order to apply the NTC to an existing circuit, design of device and cable is required, and the cost generated by changing the design may increase. Therefore, an effective method of estimating the temperature of a battery without adding an NTC is needed.

### DISCLOSURE

### TECHNICAL PROBLEM

An object of the embodiments disclosed in this document is to provide a battery temperature estimation device and an operating method thereof, which can estimate the temperature of a battery by utilizing an Electrochemical Impedance Spectroscopy (EIS) measurement value of the battery without utilizing an NTC.

Technical problems of the embodiments disclosed in this document are not limited to the technical problems mentioned above, and unmentioned other technical problems will be clearly understood by those skilled in the art from the following descriptions.

### TECHNICAL SOLUTION

A battery temperature estimation device according to an embodiment disclosed in this document may comprise: an impedance measurement unit configured to measure frequency-specific impedance of a battery; a memory configured to store a temperature-impedance imaginary part table according to a frequency; and a controller configured to estimate a temperature of the battery through the temperature-impedance imaginary part table based on an imaginary part of the frequency-specific impedance.

In an embodiment, the controller may confirm a first imaginary part of impedance corresponding to a first frequency, and estimate a first temperature corresponding to the first imaginary part based on a temperature-impedance imaginary part table corresponding to the first frequency.

In an embodiment, the controller may confirm second to fourth imaginary parts corresponding to second to fourth frequencies, estimate second to fourth temperatures corresponding to the second to fourth imaginary parts based on temperature-impedance imaginary part tables respectively corresponding to the second to fourth frequencies, and estimate an average of the first to fourth temperatures as the temperature of the battery.

In an embodiment, the memory may store a temperature-impedance imaginary part table for each of a plurality of frequencies.

In an embodiment, the controller may confirm a plurality of imaginary parts respectively corresponding to the plurality of frequencies, estimate a plurality of temperatures respectively corresponding to the plurality of imaginary parts based on temperature-impedance imaginary part tables respectively corresponding to the plurality of frequencies, and estimate the temperature of the battery based on the plurality of temperatures.

An operating method of a temperature estimation device according to an embodiment disclosed in this document may comprise may comprise: an operation of measuring frequency-specific impedance of a battery; an operation of storing a temperature-impedance imaginary part table according to a frequency; and an operation of estimating a temperature of the battery through the temperature-impedance imaginary part table based on an imaginary part of the frequency-specific impedance.

In an embodiment, the operation of estimating a temperature of the battery through the temperature-impedance imaginary part table based on an imaginary part of the frequency-specific impedance may include: an operation of confirming a first imaginary part of impedance corresponding to a first frequency; and an operation of estimating a first temperature corresponding to the first imaginary part based on a temperature-impedance imaginary part table corresponding to the first frequency.

In an embodiment, the operation of estimating a temperature of the battery through the temperature-impedance imaginary part table based on an imaginary part of the frequency-specific impedance may include: an operation of confirming second to fourth imaginary parts corresponding to second to fourth frequencies; an operation of estimating second to fourth temperatures corresponding to the second to fourth imaginary parts based on temperature-impedance imaginary part tables respectively corresponding to the second to fourth frequencies; and an operation of estimating an average of the first to fourth temperatures as the temperature of the battery.

In an embodiment, the operation of storing a temperature-impedance imaginary part table according to a frequency may include an operation of storing a temperature-impedance imaginary part table for each of a plurality of frequencies.

In an embodiment, the operation of estimating a temperature of the battery through the temperature-impedance imaginary part table based on an imaginary part of the frequency-specific impedance may include: an operation of confirming a plurality of imaginary parts respectively corresponding to the plurality of frequencies; an operation of estimating a plurality of temperatures respectively corresponding to the plurality of imaginary parts based on temperature-impedance imaginary part tables respectively corresponding to the plurality of frequencies; and an operation of estimating a temperature of the battery based on the plurality of temperatures.

### ADVANTAGEOUS EFFECTS

A battery temperature estimation device and an operating method thereof according to an embodiment disclosed in this document may estimate the core temperature of a battery by measuring EIS of the battery.

A battery temperature estimation device and an operating method thereof according to an embodiment disclosed in this document may increase SOX accuracy by accurately estimating the temperature of a battery and reduce costs according to reduction of NTC.

A battery temperature estimation device and an operating method thereof according to an embodiment disclosed in this document may estimate the temperature of a battery based on the imaginary part of frequency-specific impedance of the battery.

In addition, various effects grasped directly or indirectly may be provided through this document.

### BRIEF DESCRIPTION OF DRAWINGS

FIG. 1 is a block diagram showing a battery temperature estimation device according to an embodiment disclosed in this document.
FIGS. 2a to 2c are views showing an example of the relationship between EIS, frequency, and temperature of a battery according to an embodiment disclosed in this document.
FIG. 3 is a view showing an example of a battery temperature estimation device according to an embodiment disclosed in this document estimating the temperature of a battery.
FIG. 4 is a flowchart illustrating an operating method of a battery temperature estimation device according to an embodiment disclosed in this document.
FIGS. 5 and 6 are flowcharts specifically illustrating an operating method of a battery temperature estimation device according to an embodiment disclosed in this document.
FIG. 7 is a block diagram showing the hardware configuration of a computing system configured to perform an operating method of a battery temperature estimation device according to an embodiment disclosed in this document.

### MODE FOR INVENTION

Hereinafter, embodiments disclosed in this document will be described in detail with reference to exemplary drawings. When adding reference numerals to the components in each drawing, it should be noted that the same numerals are given to identical components as much as possible although they are shown in different drawings. In addition, in describing the embodiments disclosed in this document, when a specific description of a related known configuration or function is determined to hinder understanding of the embodiments disclosed in this document, the detailed description thereof will be omitted.

In describing the components of the embodiments disclosed in this document, terms such as first, second, A, B, (a), (b), and the like may be used. These terms are intended only to distinguish the components from other components, and the nature, order, sequence, and the like of the components are not limited by these terms. In addition, unless otherwise defined, all terms used herein, including technical or scientific terms, have the same meaning as generally understood by those skilled in the art. Terms defined in commonly used dictionaries should be interpreted as having a meaning consistent with the meaning they have in the context of related techniques, and shall not be interpreted in an ideal or excessively formal sense, unless explicitly defined in this application.

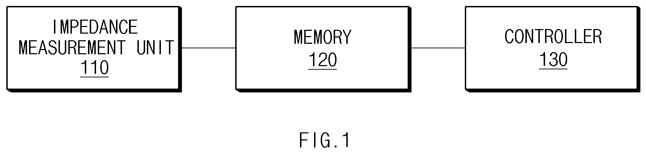

FIG. 1 is a block diagram showing a battery temperature estimation device according to an embodiment disclosed in this document.

The battery temperature estimation device 100 may be various electronic devices configured to manage, diagnose, and test batteries. According to an embodiment, the battery temperature estimation device 100 may be included in any one among a Battery Management System (BMS) inside a battery pack, a battery management server, a computer, and a cloud server. According to another embodiment, the battery temperature estimation device 100 may also be included in a device configured to test charge and discharge, such as a charge and discharge cycler.

Referring to FIG. 1, the battery temperature estimation device 100 according to an embodiment disclosed in this document may include an impedance measurement unit 110, a memory 120, and a controller 130.

The impedance measurement unit 110 may measure frequency-specific impedance of a battery. For example, the impedance measurement unit 110 may set a plurality of frequencies and measure impedance corresponding to the plurality of set frequencies. As another example, the impedance measurement unit 110 may measure frequency-specific impedance of the battery by utilizing various existing techniques for measuring impedance.

According to an embodiment, the battery may be a concept including at least any one among a battery cell, a battery module, and a battery pack.

According to an embodiment, the impedance measurement unit 110 may measure impedance at a plurality of frequencies by utilizing Fourier transform. In this case, the impedance at a plurality of frequencies may be measured more quickly than a method of separately measuring impedance at each frequency.

According to an embodiment, the impedance measurement unit 110 may measure the real part and the imaginary part of a plurality of frequency-specific impedances of the battery. As another example, the impedance measurement unit 110 may measure the magnitude and the phase of a plurality of frequency-specific impedances of the battery.

According to an embodiment, the impedance measurement unit 110 may have a configuration substantially the same as that of the controller 130 or may be implemented to be included in the controller 130.

The memory 120 may store a temperature-impedance imaginary part table according to frequency. For example, the temperature-impedance imaginary part table according to frequency may be measured in advance and stored in the memory 120. According to an embodiment, the temperature-impedance imaginary part table according to frequency may be stored in the memory 120 to correspond to each imaginary part of a plurality of impedances.

According to an embodiment, the memory 120 may store commands, control command code, control data, or user data for controlling the battery temperature estimation device 100. For example, the memory 120 may include at least one among an application program, an operating system (OS), middleware, and a device driver.

According to an embodiment, the memory 120 may include one or more among volatile memory and non-volatile memory. The volatile memory may include dynamic random-access memory (DRAM), static RAM (SRAM), synchronous DRAM (SDRAM), phase-change RAM (PRAM), magnetic RAM (MRAM), resistive RAM (RRAM), ferroelectric RAM (FeRAM), and the like. The non-volatile memory may include read only memory (ROM), programmable ROM (PROM), electrically programmable ROM (EPROM), electrically erasable programmable ROM (EEPROM), flash memory, and the like.

According to an embodiment, the memory 120 may further include a non-volatile medium such as a hard disk drive (HDD), a solid-state disk (SSD), an embedded multimedia card (eMMC), or a universal flash storage (UFS).

The controller 130 may estimate the temperature of a battery through the temperature-impedance imaginary part table based on the imaginary part of the frequency-specific impedance. For example, the controller 130 may set a first frequency, and confirm a first imaginary part of impedance corresponding to the first frequency. In addition, the controller 130 may estimate a first temperature corresponding to the first imaginary part based on a temperature-impedance imaginary part table corresponding to the first frequency.

According to an embodiment, the controller 130 may finally estimate the first temperature corresponding to the first frequency and the first imaginary part.

According to an embodiment, the controller 130 may set second to fourth frequencies among a plurality of frequencies, and confirm second to fourth imaginary parts corresponding to the second to fourth frequencies. In addition, the controller 130 may estimate second to fourth temperatures corresponding to the second to fourth imaginary parts based on a temperature-impedance imaginary part table corresponding to each of the second to fourth frequencies. In this case, the controller 130 may estimate the temperature of a battery based on the first to fourth temperatures. For example, the controller 130 may estimate an average of the first to fourth temperatures as the temperature of the battery.

According to an embodiment, the controller 130 may estimate an accurate temperature compared to a case of estimating an average of the first to fourth temperatures as the temperature of the battery. According to another embodiment, the controller 130 may select any one among the first to fourth temperatures and estimate it as the temperature of the battery. According to still another embodiment, the controller 130 may estimate the temperature of the battery based on at least any one among an arithmetic mean, a harmonic mean, and a root mean of the first to fourth temperatures.

According to an embodiment, among the frequencies, the controller 130 may set a plurality of frequencies to be used for estimation of temperature. The controller 130 may confirm a plurality of imaginary parts of impedance respectively corresponding to the plurality of frequencies. In addition, the controller 130 may estimate a plurality of temperatures respectively corresponding to the plurality of imaginary parts based on a temperature-impedance imaginary part table corresponding to each of the frequencies. In this case, the controller 130 may estimate the temperature of a battery based on the plurality of temperatures.

For example, the controller 130 may set n (n is a natural number) frequencies, and confirm n imaginary parts respectively corresponding to the n frequencies. In addition, the controller 130 may estimate n temperatures respectively corresponding to n imaginary parts from n temperature-impedance imaginary part tables respectively corresponding to the n frequencies, and may estimate an average of the n temperatures as the temperature of the battery.

According to an embodiment, the controller 130 may estimate the temperature of a battery by calculating an average, excluding the highest temperature and the lowest temperature, when there are three or more temperatures.

According to an embodiment, the controller 130 may estimate the temperature of a battery by calculating an average and a deviation of a plurality of temperatures, excluding temperatures of which the deviation is greater than a set value, and calculating an average again.

That is, according to the embodiments disclosed in this document, the battery temperature estimation device 100 may estimate the temperature of a battery based on a single frequency and a single imaginary part, and estimate the temperature of a battery based on a plurality of frequencies and a plurality of imaginary parts respectively corresponding to the plurality of frequencies.

According to an embodiment, the controller 130 may control the battery based on the estimated temperature of the battery. For example, the controller 130 may calculate the SOX (e.g., SOC, SOH, SOHQ, SOHC, etc.) of the battery based on the estimated temperature of the battery. As another example, the controller 130 may inform the user of the estimated temperature of the battery. As another example, the controller 130 may estimate the risk of fire of the battery based on the estimated temperature of the battery, and may inform the user of the estimated result or record the estimated result in a log.

According to an embodiment, the controller 130 may transmit the estimated temperature of the battery to an upper controller. The upper controller may perform various determinations on the battery based on the received temperature of the battery.

The battery temperature estimation device 100 according to an embodiment disclosed in this document may estimate the core temperature of the battery by measuring the EIS of the battery.

The battery temperature estimation device 100 according to an embodiment disclosed in this document may increase SOX accuracy by accurately estimating the temperature of a battery and reduce costs according to reduction of NTC.

The battery temperature estimation device 100 according to an embodiment disclosed in this document may estimate the temperature of a battery based on the imaginary part of frequency-specific impedance of the battery.

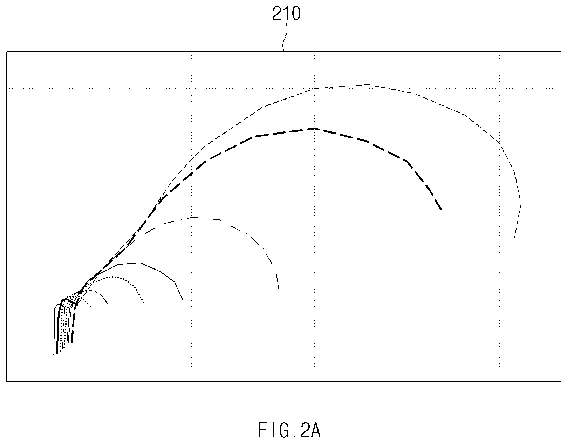

FIGS. 2a to 2c are views showing an example of the relationship between EIS, frequency, and temperature of a battery according to an embodiment disclosed in this document.

Referring to FIG. 2a, the impedance measurement unit 110 of the battery temperature estimation device 100 according to an embodiment disclosed in the present document may measure frequency-specific impedance 210 of the battery. The frequency-specific impedance 210 of the battery may be measured to be different as the temperature of the battery changes.

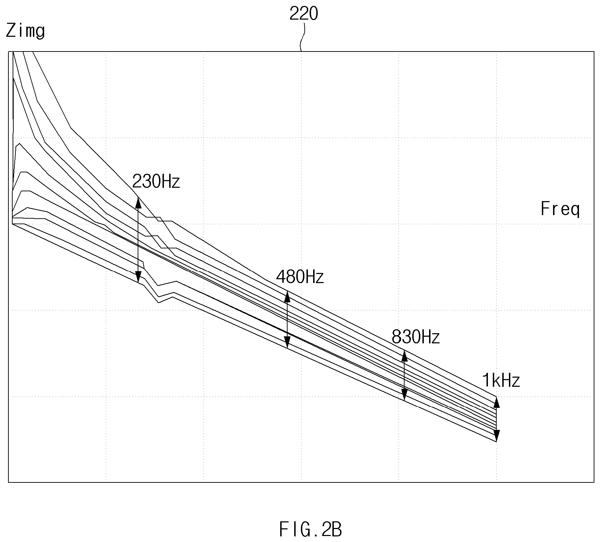

Referring to FIG. 2b, the frequency-specific impedance of the battery measured by the impedance measurement unit 110 may correspond to the frequency-impedance imaginary part 220. For example, the frequency-impedance imaginary part 220 may correspond differently according to the change in the temperature of the battery.

That is, a plurality of impedance imaginary parts may correspond to one frequency according to temperature.

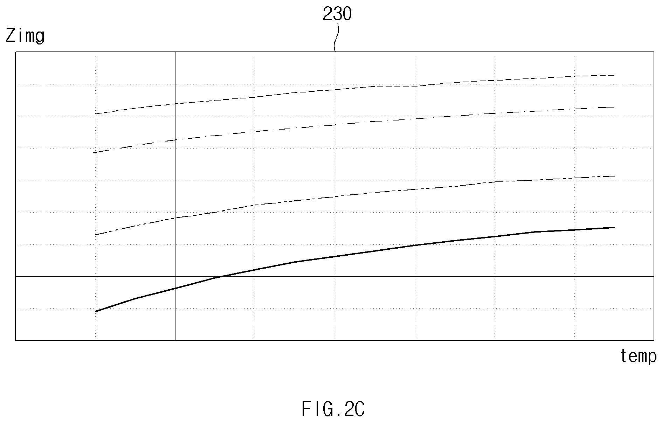

Referring to FIG. 2c, the memory 120 may store a temperature-impedance imaginary part table 230. For example, the temperature-impedance imaginary part table 230 shown in FIG. 2c may be a table corresponding to four frequencies, and the memory 120 may store a plurality of temperature-impedance imaginary part tables corresponding to a plurality of frequencies.

According to an embodiment, the temperature-impedance imaginary part table 230 may be values measured and stored in the memory 120.

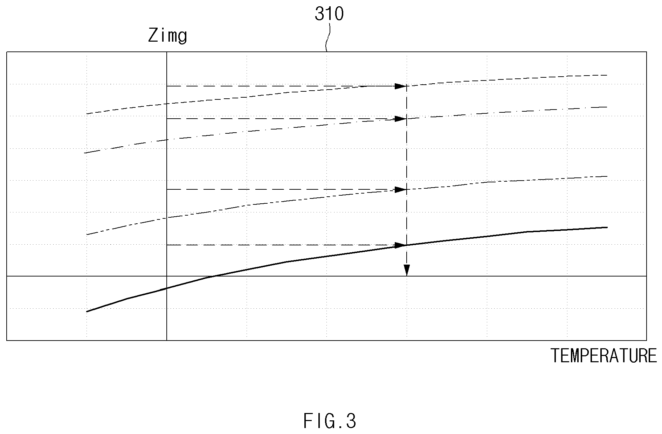

FIG. 3 is a view showing an example of a battery temperature estimation device according to an embodiment disclosed in this document estimating the temperature of a battery.

Referring to FIG. 3, the controller 130 may confirm first to fourth imaginary parts respectively corresponding to first to fourth frequencies.

In addition, the controller 130 may confirm the temperature-impedance imaginary part tables 310 respectively corresponding to the first to fourth frequencies.

The controller 130 may estimate first to fourth temperatures respectively corresponding to the first to fourth imaginary parts from the temperature-impedance imaginary part tables 310 respectively corresponding to the first to fourth frequencies.

In addition, the controller 130 may estimate the final temperature of the battery based on the first to fourth temperatures. For example, the controller 130 may estimate an average of the first to fourth temperatures as the temperature of the battery.

Although FIG. 3 shows an example in which the controller 130 estimates the temperature of a battery based on a temperature-impedance imaginary part table corresponding to the four frequencies, the battery temperature estimation device 100 according to the embodiments disclosed in this document may accurately estimate the temperature of a battery based on a temperature-impedance imaginary part table corresponding to a single or a plurality of frequencies.

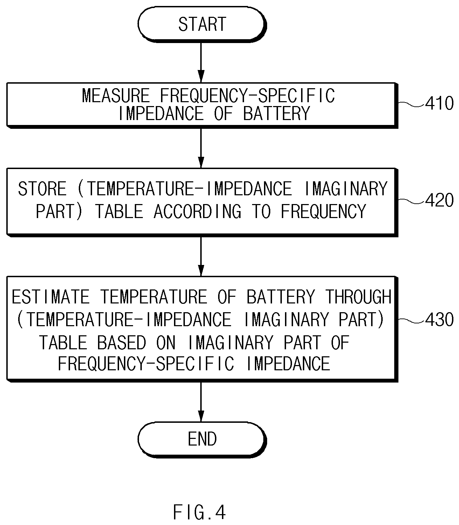

FIG. 4 is a flowchart illustrating an operating method of a battery temperature estimation device according to an embodiment disclosed in this document. According to an embodiment, the operations illustrated in FIG. 4 may be performed through the battery temperature estimation device 100 in FIG. 1.

Referring to FIG. 4, in operation 410, the impedance measurement unit 110 may measure frequency-specific impedance of a battery. For example, the impedance measurement unit 110 may set a plurality of frequencies and measure impedance corresponding to the plurality of set frequencies. As another example, the impedance measurement unit 110 may measure frequency-specific impedance of the battery by utilizing various existing techniques for measuring impedance.

According to an embodiment, the impedance measurement unit 110 may measure impedance at a plurality of frequencies by utilizing Fourier transform. In this case, the impedance at a plurality of frequencies may be measured more quickly than a method of separately measuring impedance at each frequency.

According to an embodiment, the impedance measurement unit 110 may measure the real part and the imaginary part of a plurality of frequency-specific impedances of the battery. As another example, the impedance measurement unit 110 may measure the magnitude and the phase of a plurality of frequency-specific impedances of the battery.

In operation 420, the memory 120 may store a temperature-impedance imaginary part table according to frequency. For example, the temperature-impedance imaginary part table according to frequency may be measured in advance and stored in the memory 120. According to an embodiment, the temperature-impedance imaginary part table according to frequency may be stored in the memory 120 to correspond to each imaginary part of a plurality of impedances.

According to an embodiment, operation 420 may be performed at the time of manufacturing the battery temperature estimation device 100 or before performing the operation of estimating the temperature of the battery. That is, operation 420 may be omitted.

In operation 430, the controller 130 may estimate the temperature of a battery through the temperature-impedance imaginary part table based on the imaginary part of the frequency-specific impedance. For example, the controller 130 may estimate the temperature of a battery by confirming an impedance imaginary part corresponding to the frequency and confirming a temperature-impedance imaginary part table corresponding to the frequency.

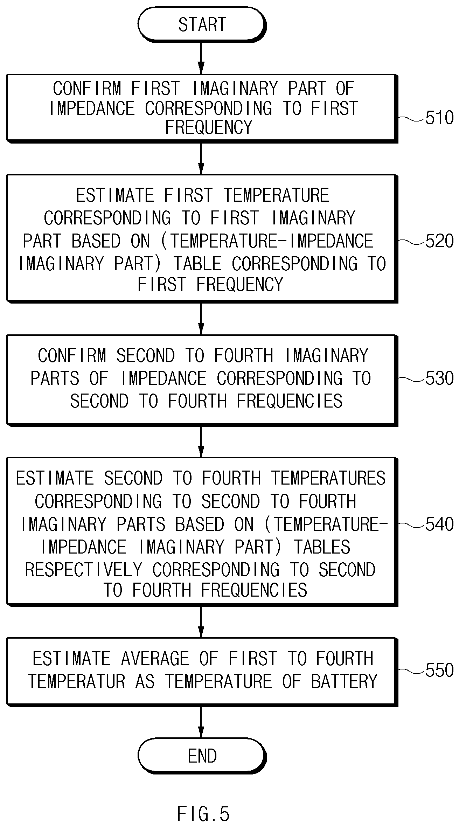

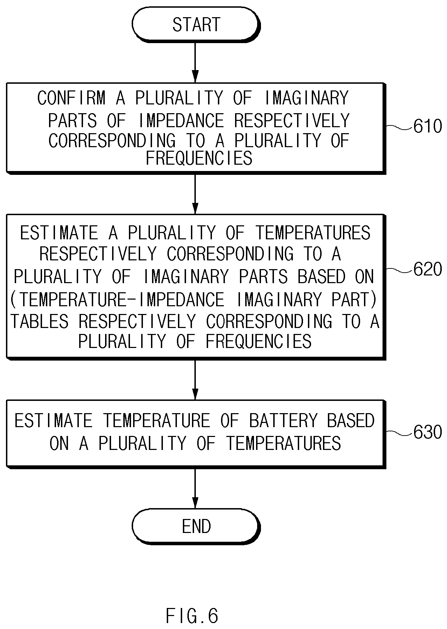

FIGS. 5 and 6 are flowcharts specifically illustrating an operating method of a battery temperature estimation device according to an embodiment disclosed in this document. According to an embodiment, the operations illustrated in FIGS. 5 and 6 may be performed through the battery temperature estimation device 100 in FIG. 1.

Referring to FIG. 5, in operation 510, the controller 130 may confirm a first imaginary part of impedance corresponding to a first frequency.

In operation 520, the controller 130 may estimate a first temperature corresponding to the first imaginary part based on a temperature-impedance imaginary part table corresponding to the first frequency.

In operation 530, the controller 130 may confirm second to fourth imaginary parts of impedance corresponding to second to fourth frequencies.

In operation 540, the controller 130 may estimate second to fourth temperatures respectively corresponding to the second to fourth imaginary parts based on temperature-impedance imaginary part tables respectively corresponding to the second to fourth frequencies.

In operation 550, the controller 130 may estimate an average of the first to fourth temperatures as the temperature of the battery.

According to an embodiment, the controller 130 may estimate the first temperature as the temperature of the battery without performing operations 530 to 550.

According to an embodiment, operations 510 to 550 may be performed to be included in operation 430 of FIG. 4.

Referring to FIG. 6, in operation 610, the controller 130 may confirm a plurality of imaginary parts of impedance respectively corresponding to a plurality of frequencies.

In operation 620, the controller 130 may estimate a plurality of temperatures respectively corresponding to a plurality of imaginary parts based on temperature-impedance imaginary part tables respectively corresponding to a plurality of frequencies.

For example, the controller 130 may set n (n is a natural number) frequencies, and confirm n imaginary parts respectively corresponding to the n frequencies. In addition, the controller 130 may estimate n temperatures respectively corresponding to n imaginary parts from n temperature-impedance imaginary part tables respectively corresponding to the n frequencies, and may estimate an average of the n temperatures as the temperature of the battery.

In operation 630, the controller 130 may estimate the temperature of the battery based on the plurality of temperatures. For example, the controller 130 may estimate an arithmetic mean of the plurality of temperatures as the temperature of the battery.

According to an embodiment, the controller 130 may estimate the temperature of a battery by calculating an average, excluding the highest temperature and the lowest temperature, when there are three or more temperatures.

According to an embodiment, the controller 130 may estimate the temperature of a battery by calculating an average and a deviation of a plurality of temperatures, excluding temperatures of which the deviation is greater than a set value, and calculating an average again.

According to an embodiment, operations 610 to 630 may be performed to be included in operation 430 of FIG. 4.

According to an embodiment, the controller 130 may control the battery based on the estimated temperature of the battery. For example, the controller 130 may calculate the SOX (e.g., SOC, SOH, SOHQ, SOHC, etc.) of the battery based on the estimated temperature of the battery. As another example, the controller 130 may inform the user of the estimated temperature of the battery. As another example, the controller 130 may estimate the risk of fire of the battery based on the estimated temperature of the battery, and may inform the user of the estimated result or record the estimated result in a log.

According to an embodiment, the controller 130 may transmit the estimated temperature of the battery to an upper controller. The upper controller may perform various determinations on the battery based on the received temperature of the battery.

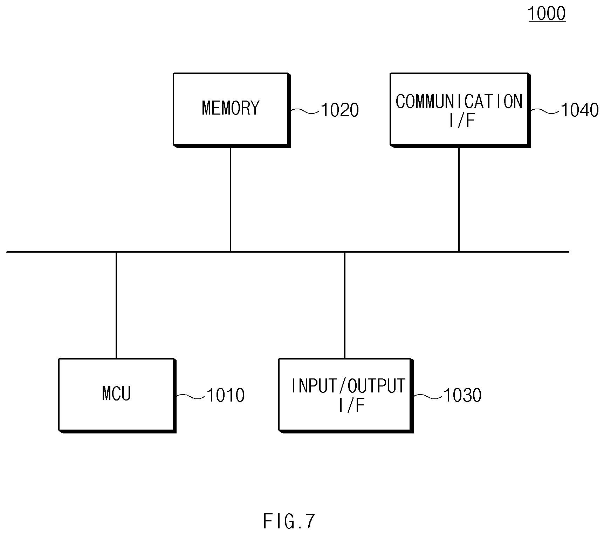

FIG. 7 is a block diagram showing the hardware configuration of a computing system configured to perform an operating method of a battery temperature estimation device according to an embodiment disclosed in this document.

Referring to FIG. 7, a computing system 1000 according to an embodiment disclosed in this document may include an MCU 1010, a memory 1020, an input/output I/F 1030, and a communication I/F 1040.

The MCU 1010 may be a processor that executes various programs (e.g., as a battery impedance measurement program, a battery temperature estimation program, and the like) stored in the memory 1020, processes various information including impedance of the battery, temperature of the battery, temperature-impedance imaginary part table of the battery, and the like through these programs, and performs the functions of the controller included in the battery temperature estimation device shown in FIG. 1 described above.

The memory 1020 may store various programs such as a battery impedance measurement program, a battery temperature estimation program, and the like. In addition, the memory 1020 may store various information including impedance of the battery, temperature of the battery, temperature-impedance imaginary part table of the battery, and the like.

The memory 1020 may be provided in plurality as needed. The memory 1020 may be volatile memory or non-volatile memory. As the volatile memory, memories 1020 such as RAM, DRAM, SRAM, and the like may be used. As the non-volatile memory, memories 1020 such as ROM, PROM, EAROM, EPROM, EEPROM, flash memories, and the like may be used. The examples of the memories 1020 listed above are only examples, and they are not limited to these examples.

The input/output I/F 1030 may provide an interface that allows transmission and reception of data between an input device (not shown) such as a keyboard, a mouse, a touch panel, or the like and an output device (not shown) such as a display or the like, and the MCU 1010.

The communication I/F 1040 is a component that can transmit and receive various data to and from the server, and may be various devices that can support wired or wireless communication. For example, the battery temperature estimation device may transmit and receive various information, including impedance of the battery, temperature of the battery, temperature-frequency table of the battery, and the like, to and from a separately provided external server through the communication I/F 1040.

In this way, as the computer program according to an embodiment disclosed in this document is recorded in the memory 1020 and processed by the MCU 1010, it can be implemented, for example, as a module that performs each of the functions shown in FIG. 2.

The above explanation only describes the technical spirit disclosed in this document as an example, and those skilled in the art in the art may make various changes and modifications without departing from the essential characteristics of the embodiments disclosed in this document.

Therefore, the embodiments disclosed in this document are not intended to limit but to explain the technical spirit of the embodiments disclosed in this document, and the scope of the technical spirit disclosed in this document is not limited by these embodiments. The protection scope of the technical spirit disclosed in this document should be interpreted by the claims provided below, and all technical spirits within the equivalent scope should be interpreted as being included in the scope of this document.

### [Description of reference symbols]

100: Battery temperature estimation device
110: Impedance measurement unit
120: Memory
130: Controller
1000: Computing system
1010: MCU
1020: Memory
1030: Input/output I/F
1040: Communication I/F

## Claims

1. A battery temperature estimation device comprising:
an impedance measurement unit configured to measure frequency-specific impedance of a battery;
a memory configured to store a temperature-impedance imaginary part table according to a frequency; and
a controller configured to estimate a temperature of the battery through the temperature-impedance imaginary part table based on an imaginary part of the frequency-specific impedance.

2. The battery temperature estimation device according to claim 1, wherein the controller confirms a first imaginary part of impedance corresponding to a first frequency, and estimates a first temperature corresponding to the first imaginary part based on a temperature-impedance imaginary part table corresponding to the first frequency.

3. The battery temperature estimation device according to claim 2, wherein the controller confirms second to fourth imaginary parts corresponding to second to fourth frequencies, estimates second to fourth temperatures corresponding to the second to fourth imaginary parts based on temperature-impedance imaginary part tables respectively corresponding to the second to fourth frequencies, and estimates an average of the first to fourth temperatures as the temperature of the battery.

4. The battery temperature estimation device according to claim 1, wherein the memory stores a temperature-impedance imaginary part table for each of a plurality of frequencies.

5. The battery temperature estimation device according to claim 4, wherein the controller confirms a plurality of imaginary parts respectively corresponding to the plurality of frequencies, estimates a plurality of temperatures respectively corresponding to the plurality of imaginary parts based on temperature-impedance imaginary part tables respectively corresponding to the plurality of frequencies, and estimates the temperature of the battery based on the plurality of temperatures.

6. An operating method of a temperature estimation device, the method comprising:
an operation of measuring frequency-specific impedance of a battery;
an operation of storing a temperature-impedance imaginary part table according to a frequency; and
an operation of estimating a temperature of the battery through the temperature-impedance imaginary part table based on an imaginary part of the frequency-specific impedance.

7. The operating method of a temperature estimation device according to claim 6, wherein the operation of estimating a temperature of the battery through the temperature-impedance imaginary part table based on an imaginary part of the frequency-specific impedance includes:
an operation of confirming a first imaginary part of impedance corresponding to a first frequency; and.
an operation of estimating a first temperature corresponding to the first imaginary part based on a temperature-impedance imaginary part table corresponding to the first frequency.

8. The operating method of a temperature estimation device according to claim 7, wherein the operation of estimating a temperature of the battery through the temperature-impedance imaginary part table based on an imaginary part of the frequency-specific impedance includes:
an operation of confirming second to fourth imaginary parts corresponding to second to fourth frequencies;
an operation of estimating second to fourth temperatures corresponding to the second to fourth imaginary parts based on temperature-impedance imaginary part tables respectively corresponding to the second to fourth frequencies; and
an operation of estimating an average of the first to fourth temperatures as the temperature of the battery.

9. The operating method of a temperature estimation device according to claim 6, wherein the operation of storing a temperature-impedance imaginary part table according to a frequency includes an operation of storing a temperature-impedance imaginary part table for each of a plurality of frequencies.

10. The operating method of a temperature estimation device according to claim 9, wherein the operation of estimating a temperature of the battery through the temperature-impedance imaginary part table based on an imaginary part of the frequency-specific impedance includes:
an operation of confirming a plurality of imaginary parts respectively corresponding to the plurality of frequencies;
an operation of estimating a plurality of temperatures respectively corresponding to the plurality of imaginary parts based on temperature-impedance imaginary part tables respectively corresponding to the plurality of frequencies; and
an operation of estimating a temperature of the battery based on the plurality of temperatures.
